# EUROPEAN PATENT SPECIFICATION

(11) **EP 0 351 174 B1**
(45) Date of publication and mention of the grant of the patent: **17.05.1995**
(21) Application number: 89307003.7
(22) Date of filing: 10.07.1989
(51) Int. Cl.: G01R 1/073, G01R 31/28

(54) **Board alignment system**
Ausrichtungssystem für gedruckte Schaltungskarten
Système d'alignement de carte

(30) Priority: 13.07.1988 US 219033
(43) Date of publication of application: 17.01.1990
(73) Proprietor: Hewlett-Packard Company, Palo Alto, California 94304 (US)
(72) Inventor: Kanack, Kris Jerome, Loveland, CO 80538 (US); Hayes, James Michael, Loveland, CO 80538 (US)
(74) Representative: Williams, John Francis

(56) References cited:
- EP-A- 0 255 909
- DE-A- 3 020 877
- DE-A- 3 136 896
- IBM TECHNICAL DISCLOSURE BULLETIN, vol. 26, no. 12, May 1984, pages 6350-6352,New York, US; J.E. KNUDSON et al.: "Adjustable backer plate for logic cardtesting"

## Description

This invention relates to testing of printed circuit boards. More particularly, this invention relates to systems and techniques for aligning a printed circuit board with testing apparatus and starts from EP-A-0 255 909.

In automated testing of printed circuit boards it is necessary to align the printed circuit board with the probes of the test fixture. Conventionally this may be done by means of alignment holes in the printed circuit board which are adapted to be aligned with alignment pins carried by the fixture.

Many prior art printed circuit board fixtures such as that disclosed in DE-A-3 020 877 have used alignment pins which are of uniform diameter along their length and have a fixed length. The diameter of the alignment pins must be closely sized to the diameter of the alignment holes in the printed circuit board to ensure proper positioning of the board for testing. This is necessary because the probes of the testing unit must contact the proper electronic devices and electrical contacts on the board in order for reliable testing to be conducted.

However, exact positioning of the board is not possible due to clearances between the alignment holes in the printed circuit board and alignment pins in the test fixture. These clearances must exist due to manufacturing tolerances in the diameter and position of the alignment pins in the test fixture.

In the arrangement of EP-A-0 255 909 the corresponding pin member (Zs), which is adapted to engage in an alignment opening (Zb) in a printed circuit board to align the test fixture, has a body portion of diameter which is greater than the diameter of the alignment opening and an end which has an inner cylindrical portion of diameter substantially equal to the diameter of the alignment opening and an outer portion tapering from the diameter of the cylindrical portion to a smaller diameter.

According to the arrangement disclosed in EP-A- 0 255 909, when the pin member (Zs) is moved into engagement with the printed circuit board, the tapered portion of the end of the pin member enters the alignment opening followed by the cylindrical portion of the end of the pin member. The body portion of the pin member does not enter the opening. For accurate alignment of the test fixture it is necessary for the diameter of the cylindrical portion to be the same as the diameter of the alignment opening. If the diameter of the alignment opening is greater than the diameter of the cylindrical portion of the pin member, the test fixture will not be accurately aligned with the printed circuit board.

Thus, it has been necessary to maintain proper selection of alignment pins, and also maintain proper tolerances, to assure that a printed circuit board is properly aligned in the fixture for desired testing.

IBM Technical Disclosure Bulletin, Vol. 26, No. 12, May 1984, page 6350 discloses a further alignment system. The alignment pins have an oversized section which aids alignment. However, the pins are not spring mounted and the circuit testing pins can not be biased towards the circuit under test.

Accordingly, the invention provides a board alignment system for alignment of a printed circuit board in a test fixture, wherein said printed circuit board includes at least two alignment openings therein, said alignment system comprising: at least two pin members each comprising an elongated body portion having first and second ends, wherein said second end is tapered to a diameter smaller than the diameter of said body portion, wherein said first end of each said pin member is supported by said fixture; wherein said second end of each said pin member projects outwardly; wherein each said pin member is adapted to telescope between a normally extended position and a retracted position; said system further comprising bias means adapted to urge each said pin member toward said normally extended position; characterised in that said body portion of each said pin member has a diameter larger than the diameter of a said alignment opening, and in that the second end tapers from a diameter larger than said alignment openings to a diameter smaller than said alignment openings, wherein said second end of each said pin member is adapted to engage a said alignment opening and remove clearance between said second end of said pin member and said opening; in that the system further comprises a tubular housing secured to said fixture; said housing having an open end and said first end of said pin member being slidably received in said open end of said housing, and in that at least about 50% of the length of the pin member remains in said tubular housing.

In accordance with the present invention there is provided a board alignment system for alignment of a printed circuit board in a test fixture. The alignment system comprises a telescoping pin having one end supported or carried by the test fixture and the other end projecting outwardly. The distal end of the pin is tapered to a smaller diameter than the body portion of the pin.

The pin is adapted to telescope between a normally extended position and a retracted position. Bias means (e.g., a coiled spring) urges the pin toward its normally extended position.

Because the other or distal end of the pin is tapered (i.e., of a smaller diameter), it can easily be started into the alignment holes in the printed circuit board (even when the board is slightly out of proper position and even when the alignment holes are under-sized). The spring force urges the tapered end of the pin into the alignment holes regardless of the diameter of the hole.

Thus, tolerance problems are avoided. Also, the diameter of the alignment hole is not critical. Further, small target areas on the printed circuit board can be contacted with probes for testing because of the greater accuracy in alignment of the board in the test fixtures. Greater accuracy in alignment is possible due to the elimination of clearance between the alignment holes in the printed circuit board and the tapered alignment pins.

A further advantage of the present invention is that a wide range of printed circuit board hole diameters can be accommodated with the novel alignment pin assembly.

This arrangement also enables larger diameter alignment pins to be used. The larger diameter pins are stiffer than normal alignment pins. Consequently, the test assembly is stiffer than when using conventional pins.

Other advantages of the alignment system of the invention will be apparent from the following detailed description and the accompanying drawings.

The invention is described in more detail hereinafter with reference to the accompanying drawings, wherein like reference characters refer to the same parts throughout the several views and in which:
FIGURE 1 is an elevational, cross-sectional view of one embodiment of a telescoping alignment pin useful in this invention;
FIGURE 2 is a front elevational view of one embodiment of an alignment pin which is useful in this invention;
FIGURE 3 is a side elevational view of the alignment pin of Figure 2;
FIGURE 4 is a side elevational view of a preferred embodiment of guide bushing used in the assembly of the invention;
FIGURE 5 is a cross-sectional view of the guide bushing shown in Figure 4, taken along line 5-5;
FIGURE 6 is a front elevational view of another embodiment of alignment pin useful in the invention;
FIGURE 7 is a side elevational view of a preferred embodiment of stop member useful in the assembly of the invention;
FIGURES 8 and 8A are side elevational, partially cut-away, views illustrating use of alignment assemblies of the invention mounted in a fixture, with a printed circuit board placed over the pins for alignment purposes; and
FIGURE 9 is an elevational, cross-sectional view of another embodiment of alignment pin assembly of this invention.

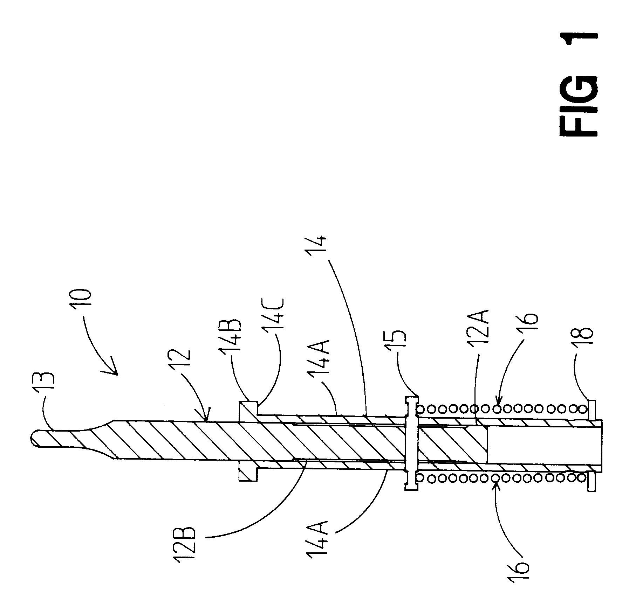

In Figure 1 there is shown an elevational, partially cut-away view of one embodiment of a telescoping alignment pin 10 of the invention. Elongated pin member 12 is slidably received in an elongated tubular housing 14. The upper end 13 of the pin is tapered to a smaller diameter than the main body portion of the pin.

The pin 12 is closely received in housing 14 in a manner such that the pin can move longitudinally with respect to housing 14 without binding. Yet, the fit between the pin and the interior of the housing is sufficiently close that the pin cannot wobble or move laterally within the housing. A portion 12B of the pin 12 may be removed as shown so that there is no possibility of binding between this portion and the interior of the housing. The end 12A of the pin is of the same diameter as the main body portion of the pin.

A horizontal pin or shaft 15 passes through a transverse opening in pin 12, as shown, and the outer ends of the shaft serve as stop means for the upper end of coiled spring 16 which encircles housing 14. Stop means 18 is secured at the lower end of the tubular housing 14 to secure the lower end of spring 16. Stop means 18 may be, for example, a spring clip which is detachably secured to the lower end of the housing 14.

The upper end of the housing 14 includes an enlarged shoulder 14B which has a face 14C which is perpendicular to the longitudinal centerline of the housing. This shoulder and face assure that the housing is properly oriented when it is mounted in an opening in a substrate (such as a probe plate in a test fixture).

The external surface also includes a plurality of barbs 14A which assist in securing the housing in the desired substrate. The barbs ensure centering and perpendicularity of mounting the housing in the substrate.

The housing includes slotted apertures in opposing side walls of the housing through which the ends of shaft 15 project. When downward pressure is exerted on the end 13 of pin 12, the pin 12 can be urged downwardly in the housing against the force of the coiled spring 16. When the force is removed from pin 12 the spring 16 urges the pin upwardly again to its uppermost position.

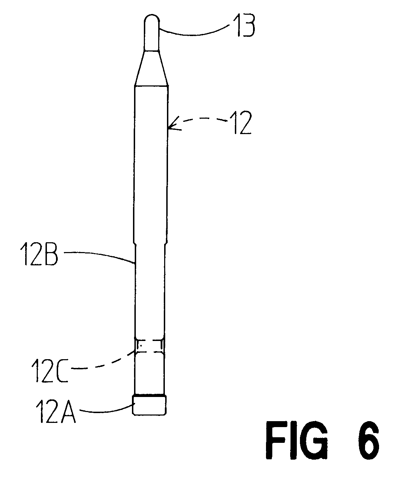

Figure 6 is a front elevational view of the pin 12. Aperture 12C extends transversely through the pin to receive shaft 15.

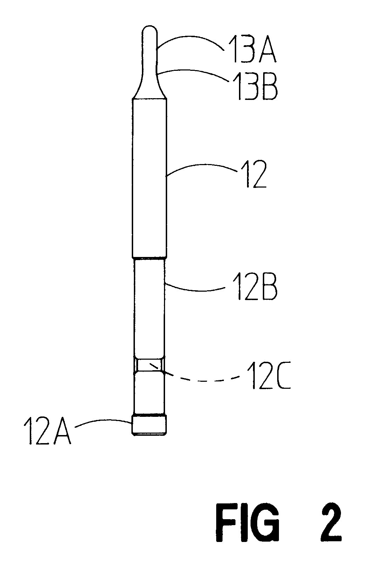

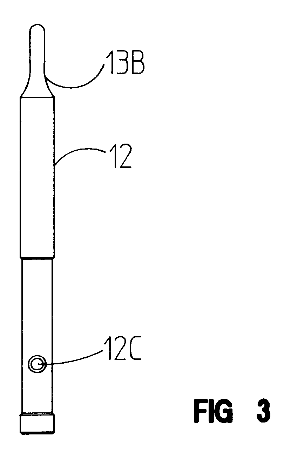

Figure 2 is a front elevational view of another embodiment of pin member 12 having a different type of tapered end 13A. In this embodiment the taper includes a curved surface 13B (as opposed to the linear slope of the tapered end of the embodiment shown in Figure 1). Figure 3 is a side elevational view of the embodiment shown in Figure 2.

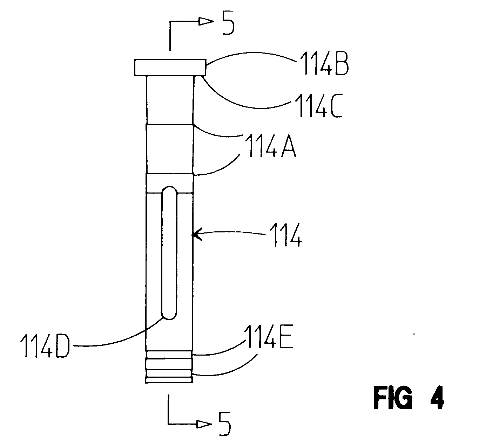

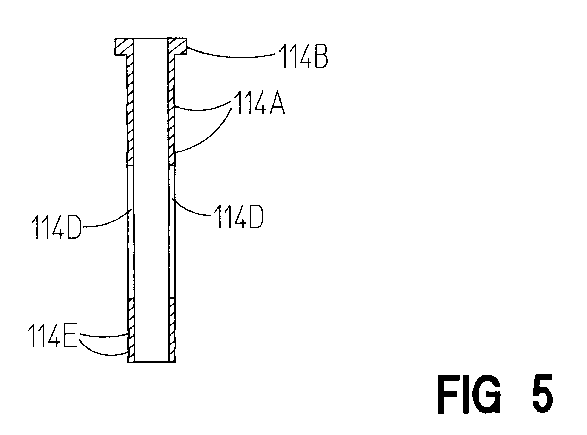

Figure 4 is a side elevational view of another embodiment of tubular housing 114 having an enlarged shoulder 114B which includes a face 114C which is perpendicular to the longitudinal centerline of the housing. The external surface of the housing includes a plurality of barbs 114A. Figure 5 is a cross-sectional view of the housing taken along line 5-5 in Figure 4.

The housing 114 also includes an elongated slotted aperture 114D in each of two opposing side walls of the housing. One end of the housing includes recessed grooves 114E, as illustrated. The purpose of these grooves is for the placement of a clip member to retain the lower end of a coiled spring as illustrated in Figure 1. By having more than one groove 114E, the clip member could be placed on the housing at either location. By placing the clip in the upper groove the spring is compressed more than when the clip is placed in the lower groove. This then provides more upward force against the pin member.

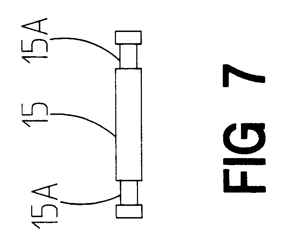

Figure 7 is a front elevational view of a preferred embodiment of shaft 15 which is useful as a stop member for the upper end of spring 16, as illustrated in Figure 1. Each end of the shaft includes a recessed groove or channel 15A to assist in retaining the upper end of the coiled spring 16 in proper position.

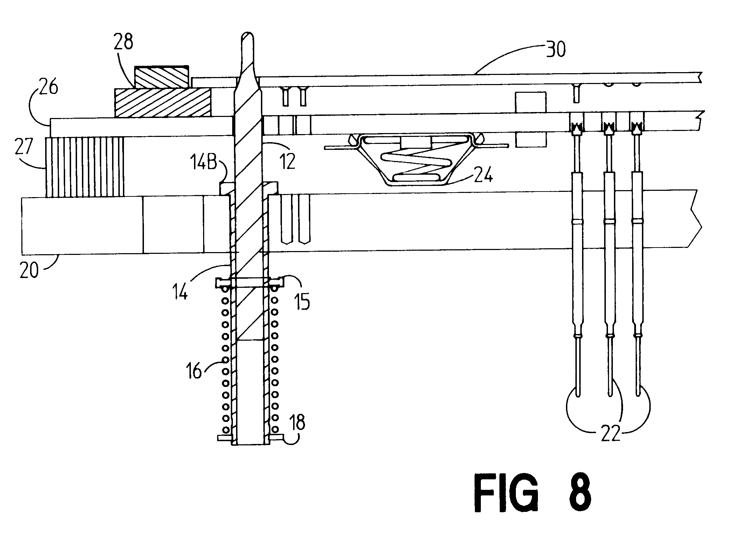

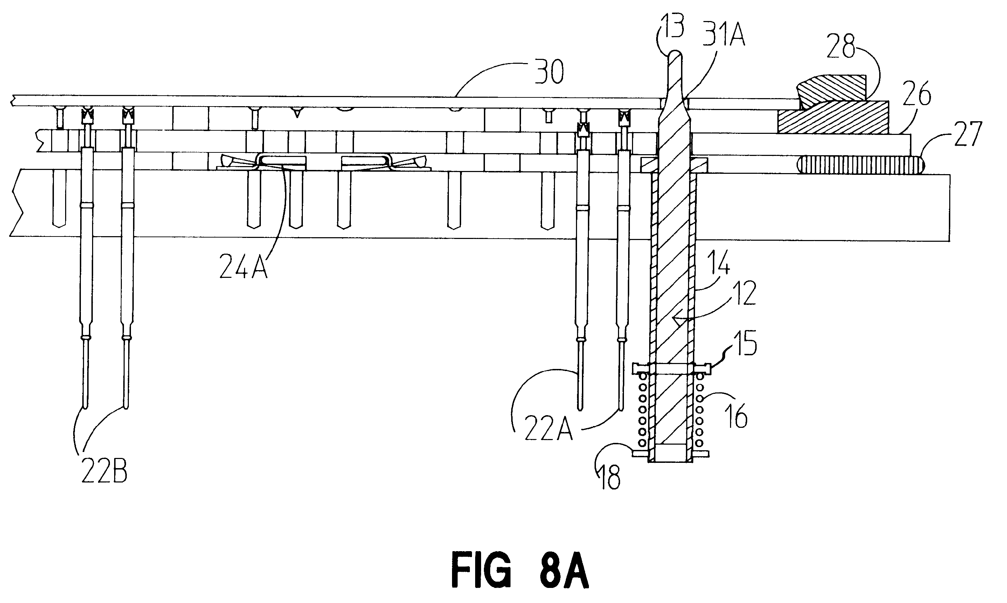

As illustrated in Figures 8 and 8A, the alignment pin assembly of the invention can be carried by a probe plate in a board testing fixture. Normally there are two or more such alignment pin assemblies used in such a probe plate. When two such alignment pins are used they are placed at opposite diagonal corners of the fixture.

Figure 8 illustrates one corner section of the testing fixture in which an alignment pin assembly 10 is used. In this view the pin is in its fully extended position. Figure 8A illustrates the opposite corner section of the testing fixture of Figure 8 after vacuum has been drawn to force the printed circuit board downwardly against the test probes and the alignment pin.

The tubular housing or guide bushing 14 is inserted into an opening in probe plate 20, as illustrated. The housing has a length greater than the thickness of the probe plate so that the housing extends completely through the probe plate. The upper end 13 of pin 12 extends into an alignment or tooling hole 31 in printed circuit board 30.

Gasket 27 is positioned between the edge of the probe plate and the support plate 26, and gasket 28 is positioned between the edge of printed circuit board 30 and the upper surface of support plate 26. A pre-loaded spring 24 is positioned between the support plate and the probe plate. The pre-loaded spring urges the support plate upwardly away from the probe plate.

Probes 22 are carried by the probe plate and extend through openings in support plate 26. When the printed circuit board is drawn downwardly toward the probe plate by vacuum, the upper ends of the probes contact the appropriate electronic devices or contacts on the printed circuit board for testing.

Figure 8A illustrates the assembly after the printed circuit board has been forced downwardly by atmospheric pressure due to a vacuum being created between the probe plate and the board. The various probes 22A and 22B are in contact with the appropriate contacts on the board for testing purposes. Spring 24A is in collapsed position. Alignment pin 12 has been forced downwardly into housing 14. Coiled spring 16 pushes upwardly to urge pin 12 against the board 30. The tapered end 13 of pin 12 centers itself in the opening 31A in board 30. In the alignment pin assembly of the invention at least about 50% of the length of the movable pin is disposed within the tubular housing at all times. This assures that the pin will be properly supported and will not wobble or otherwise move laterally relative to the housing Movement of the pin should only be in the longitudinal direction.

The length of the pin and the housing may vary. Typically the length of the pin is in the range of about 25.4mm to 76.2mm (1 to 3 inches). At least about 50% (and more preferably about 70%) of the length of the pin is disposed within the housing at all times. If desired, a portion of the length of the pin within the housing may include a recess (as illustrated in Figures 1, 2, 3 and 6). In such event, however, the lower end of the pin must be the same diameter as the main body portion of the pin so as to maintain proper alignment of the pin within the housing.

The lower end of the housing may be open, if desired.

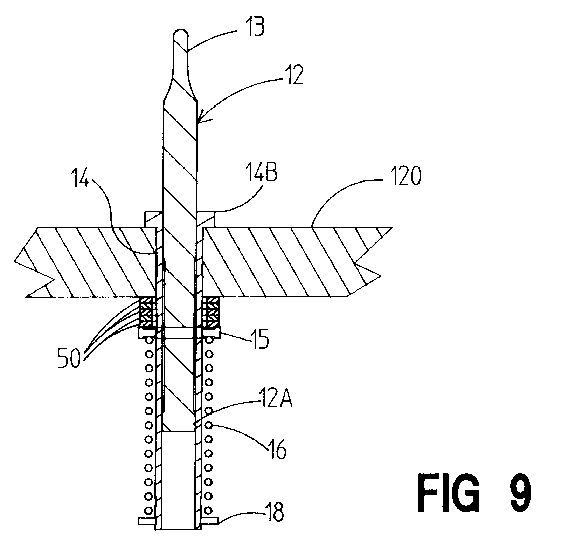

As illustrated in Figure 9, it is possible to place washers or spacers (50) between the stop (15) and the bottom side of the mounting substrate (e.g., probe plate (120)) in order to partially compress spring (16). This results in an adjustment of the uppermost position of pin (12). In other words, by placing washers or spacers around housing 14 next to the mounting substrate, the pin (12) is limited in its upward travel (because stop (15) is limited in its upward travel). In this manner the spacers serve as adjustment means for adjusting the outermost position of the pin relative to the housing.

## Claims

1. Board alignment, system for alignment of a printed circuit board (30) in a test fixture, wherein said printed circuit board (30) includes at least two alignment openings (31A) therein, said alignment system comprising: at least two pin members (12) each comprising an elongated body portion (12B) having first (12A) and second (13) ends, wherein said second end (13) is tapered to a diameter smaller than the diameter of said body portion (12B), wherein said first end (12A) of each said pin member (12) is supported by said fixture; wherein said second end (13) of each said pin member (12) projects outwardly; wherein each said pin member (12) is adapted to telescope between a normally extended position and a retracted position; said system further comprising bias means (16) adapted to urge each said pin member (12) toward said normally extended position; characterised in that said body portion of each said pin member (12) has a diameter larger than the diameter of a said alignment opening (31A), and in that the second end tapers from a diameter larger than said alignment openings to a diameter smaller than said alignment opening, wherein said second end (13) of each said pin member (12) is adapted to engage a said alignment opening (31A) and remove clearance between said second end (13) of said pin member (12) and said opening (31A), in that the system further comprises a tubular housing (14) secured to said fixture; said housing (14) having an open end and said first end (13) of said pin member (12) being slidably received in said open end of said housing (14), and in that at least about 50% of the length of the pin member (12) remains in said tubular housing when said pin member (12) is in said extended position.

2. An alignment system according to claim 1, wherein said bias means comprises a spring (16).

3. An alignment system according to claim 2, wherein said bias means comprises a coiled spring (16).

4. An alignment system according to claims 2 or 3, further comprising first and second stop members; wherein said first stop member (18) is carried by said housing (14) and said second stop member (15) is carried by said first end (12A) of said pin member (12); wherein said housing includes a wall having a longitudinal, elongated, slotted aperture (114D) therein; wherein said second stop member projects through said slotted aperture; and wherein said spring (16) is retained between said first and second stop member.

5. An alignment system according to claim 4 when appended to claim 3, wherein said housing (14) includes two said slotted apertures (114D) which are disposed on opposite sides of said housing; wherein said second stop member (15) carried by said pin member (12) projects outwardly through each of said slotted apertures (114D); and wherein said a coiled spring (16) encircles said tubular housing (14).

6. An alignment system according to any preceding claims, further comprising adjustment means (50) for adjusting the outermost position of said pin member (12) relative to said housing (14).

7. An alignment system according to claim 6, wherein said adjustment means (50) comprises a spacer member (50) disposed on said housing (14) which is adapted to limit outward movement of said pin member (12) relative to said housing.

## Patentansprüche

1. Platinenausrichtungssystem zum Ausrichten einer gedruckten Schaltungsplatine (30) in einer Testvorrichtung, wobei die gedruckte Schaltungsplatine (30) zumindest zwei Ausrichtungsöffnungen (31A) in derselben aufweist, wobei das Ausrichtungssystem folgende Merkmale aufweist: zumindest zwei Stiftbauglieder (12), von denen jedes einen länglichen Körperabschnitt (12B) mit einem ersten (12A) und einem zweiten (13) Ende aufweist, wobei das zweite Ende (13) auf einen Durchmesser verjüngt ist, der kleiner als der Durchmesser des Körperabschnitts (12B) ist, wobei das erste Ende (12A) jedes Stiftbauglieds (12) von der Vorrichtung getragen wird; wobei das zweite Ende (13) jedes Stiftbauglieds (12) nach außen vorsteht; wobei jedes Stiftbauglied (12) angepaßt ist, um zwischen einer normal verlängerten Position und einer zurückgezogenen Position ausziehbar zu sein; wobei das System ferner eine Vorspannungseinrichtung (16) aufweist, die angepaßt ist, um das Stiftbauglied (12) in die normal verlängerte Position zu drücken; dadurch gekennzeichnet, daß der Körperabschnitt jedes Stiftbauglieds (12) einen Durchmesser aufweist, der größer als der Durchmesser der Ausrichtungsöffnung (31A) ist, und daß sich das zweite Ende von einem Durchmesser, der größer als die Ausrichtungsöffnungen ist, zu einem Durchmesser, der kleiner als die Ausrichtungsöffnung ist, verjüngt, wobei das zweite Ende (13) jedes Stiftbauglieds (12) angepaßt ist, um eine der Ausrichtungsöffnungen (31A) in Eingriff zu nehmen und einen Zwischenraum zwischen dem zweiten Ende (13) des Stiftbauglieds (12) und der Öffnung (31A) zu beseitigen, daß das System ferner ein röhrenförmiges Gehäuse (14) aufweist, das fest an der Vorrichtung befestigt ist; daß das Gehäuse (14) ein offenes Ende besitzt und das erste Ende (13) des Stiftbauglieds (12) gleitfähig in das offene Ende des Gehäuses (14) aufgenommen ist und daß mindestens 50% der Länge des Stiftbauglieds (12) in dem röhrenförmigen Gehäuse verbleiben, wenn das Stiftbauglied (12) in der verlängerten Position ist.

2. Ein Ausrichtungssystem gemäß Anspruch 1, bei dem die Vorspannungseinrichtung eine Feder (16) aufweist.

3. Ein Ausrichtungssystem gemäß Anspruch 2, bei dem die Vorspannungseinrichtung eine Schraubenfeder (16) aufweist.

4. Ein Ausrichtungssystem gemäß den Ansprüchen 2 oder 3, das ferner ein erstes und ein zweites Anschlagbauglied aufweist; wobei das erste Anschlagbauglied (18) von dem Gehäuse (14) getragen wird und das zweite Anschlagbauglied (15) von dem ersten Ende (12A) des Stiftbauglieds (12) getragen wird; wobei das Gehäuse eine Wand mit einer longitudinalen länglichen geschlitzten Öffnung (114D) in derselben aufweist; wobei das zweite Anschlagbauglied durch die geschlitzte Öffnung ragt; und wobei die Feder (16) zwischen dem ersten und dem zweiten Anschlagbauglied zurückgehalten ist.

5. Ein Ausrichtungssystem gemäß Anspruch 4 in Rückbezug auf Anspruch 3, bei dem das Gehäuse (14) die zwei geschlitzten Öffnungen (114D) einschließt, die auf gegenüberliegenden Seiten des Gehäuses angeordnet sind; bei dem das zweite Anschlagbauglied (15), das von dem Stiftbauglied (12) getragen wird, durch jede der geschlitzten Öffnungen (114D) nach außen vorsteht; und bei dem die Schraubenfeder (16) das röhrenförmige Gehäuse (14) umgibt.

6. Ein Ausrichtungssystem gemäß einem beliebigen vorhergehenden Anspruch, das ferner eine Einstellungseinrichtung (50) zum Einstellen der äußersten Position des Stiftbauglieds (12) relativ zu dem Gehäuse (14) aufweist.

7. Ein Ausrichtungssystem gemäß Anspruch 6, bei dem die Einstellungseinrichtung (50) ein Beabstandungsbauglied (50) aufweist, das auf dem Gehäuse (14) angeordnet ist, das angepaßt ist, um die Bewegung des Stiftbauglieds (12) relativ zu dem Gehäuse nach außen zu begrenzen.

## Revendications

1. Système d'alignement de cartes destiné à l'alignement d'une carte (30) de circuits imprimés dans un appareillage d'essais, dans lequel ladite carte (30) de circuits imprimés comprend au moins deux orifices (31A) pour alignement qui y sont ménagés, ledit système d'alignement comportant: au moins deux organes formant broches (12) chacun comportant une portion allongée formant corps (12B) qui possède une première extrémité (12A) et une seconde extrémité (13), dans lequel ladite seconde extrémité (13) a une section décroissante jusqu'à un diamètre plus petit que le diamètre de ladite portion formant corps (12B), dans lequel ladite première extrémité (12A) de chacun desdits organes formant broches (12) est supportée par ledit appareillage; dans lequel ladite seconde extrémité (13) de chacun desdits organes formant broches (12) fait saillie vers l'extérieur; dans lequel chacun desdits organes formant broches (12) est apte à coulisser télescopiquement entre une position normale en extension et une position rétractée; ledit système comportant en outre un moyen (16) de compression apte à pousser chacun desdits organes formant broches (12) vers ladite position normale en extension; caractérisé en ce que ladite portion formant corps de chacun desdits organes formant broches (12) présente un diamètre plus grand que le diamètre d'un orifice pour alignement précité (31A), et en ce que la seconde extrémité a une section décroissante à partir d'un diamètre plus grand que lesdits orifices pour alignement jusqu'à un diamètre plus petit que ledit orifice pour alignement, dans lequel ladite seconde extrémité (13) de chacun desdits organes formant broches (12) est apte à s'engager dans un orifice pour alignement précité (31A) et à éliminer le jeu entre ladite seconde extrémité (13) dudit organe formant broche (12) et ledit orifice (31A); en ce que ce système comporte en outre un logement tubulaire (14) assujetti audit appareillage; ledit logement (14) possédant une extrémité ouverte et ladite première extrémité (13) dudit organe formant broche (12) trouvant sa place avec la faculté de coulisser dans ladite extrémité ouverte dudit logement (14), et en ce que au moins environ 50% de la longueur de l'organe formant broche (12) demeure dans ledit logement tubulaire lorsque ledit organe formant broche (12) est dans ladite position en extension.

2. Système d'alignement selon la revendication 1, dans lequel ledit moyen de compression comporte un ressort (16).

3. Système d'alignement selon la revendication 2, dans lequel ledit moyen de compression comporte un ressort en spirale (16).

4. Système d'alignement selon la revendication 2 ou la revendication 3, comportant en outre un premier et un second organes formant butées d'arrêt; dans lequel ledit premier organe (18) formant butée d'arrêt est monté sur ledit logement (14) et ledit second organe (15) formant butée d'arrêt est monté sur ladite première extrémité (12A) dudit organe formant broche (12); dans lequel ledit logement comprend une paroi présentant une ouverture longitudinale, allongée en fente (114D) qui y est ménagée; dans lequel ledit second organe formant butée d'arrêt fait saillie à travers ladite ouverture en fente; et dans lequel ledit ressort (16) est maintenu entre lesdits premier et second organes formant butées d'arrêt.

5. Système d'alignement selon la revendication 4 lorsque jointe à la revendication 3, dans lequel ledit logement (14) comprend deux ouvertures en fentes précitées (114D) qui sont disposées sur des côtés opposés dudit logement; dans lequel ledit second organe formant butée d'arrêt (15) monté sur ledit organe formant broche (12) fait saillie vers l'extérieur à travers chacune desdites ouvertures en fentes (114D); et dans lequel un tel ressort précité (16) entoure le logement tubulaire (14).

6. Système d'alignement selon l'une quelconque des revendications précédentes, comportant en outre des moyens (50) de réglage destinés à régler la position la plus écartée dudit organe formant broche (12) par rapport audit logement (14).

7. Système d'alignement selon la revendication 6, dans lequel lesdits moyens de réglage (50) comportent un organe formant écarteur (50) disposé sur ledit logement (14) et qui est apte à limiter un déplacement vers l'extérieur dudit organe formant broche (12) par rapport audit logement.
